# EUROPEAN PATENT APPLICATION

(11) **EP 2 940 744 A1**
(43) Date of publication of application: **04.11.2015**
(21) Application number: 13868246.3
(22) Date of filing: 27.12.2013
(51) Int. Cl.: H01L 33/50, C09K 3/10, C09K 11/02, C09K 11/08

(54) **PHOSPHOR DISPERSION, LED DEVICE AND METHOD FOR MANUFACTURING SAME**

(30) Priority: 27.12.2012 JP 2012284875
(71) Applicant: Konica Minolta, Inc., Tokyo 100-7015 (JP)
(72) Inventor: SATO, Atsushi, Tokyo 100-7015 (JP)
(74) Representative: Henkel, Breuer & Partner
(86) International application number: PCT/JP2013/007680
(87) International publication number: WO 2014/103330

(57) **Abstract**

The purpose of the present invention is to provide an LED device having a wavelength conversion layer, which has high durability and is suppressed in chromaticity variation (chromaticity variation of emitted light among devices) and chromaticity unevenness (chromaticity unevenness of emitted light in one light emitting device). This purpose is achieved by a phosphor dispersion which contains phosphor particles, fine light scattering particles, layered clay mineral particles, silicon oxide particles and a solvent, with the content of the fine light scattering particles being 0.1-2.5% by mass.

## Description

### Technical Field

The present invention relates to a phosphor dispersion liquid for manufacturing an LED device, an LED device and a method for manufacturing the LED device.

### Background Art

Recently, techniques for obtaining a white Light Emitting Diode (LED) device have been widely used, in which a phosphor such as YAG phosphor is disposed in the vicinity of a gallium nitride (GaN)-based blue LED chip, and blue light emitted from the blue LED chip and secondary-emitted yellow light from the phosphor receiving the blue light, are mixed to obtain white light.

In such a white LED device, an LED chip or mounted components may be encapsulated with an encapsulating film by applying and curing a transparent resin or a precursor of a transparent ceramic including phosphors dispersed therein. However, since the specific gravity of a phosphor is greater than that of a transparent resin or a precursor of a transparent ceramic, the phosphor settles before curing of the transparent resin or the precursor of the transparent ceramic, causing chromaticity unevenness, low efficiency or the like of lights emitted from the white LED.

Several methods are proposed for suppressing the phosphor settling to prevent the chromaticity unevenness. For example, PTL 1 discloses that the settling or segregation of phosphors is suppressed when a silicone resin having the viscosity during the resin curing of 100 to 10,000mPa·s is used. PTL 2 discloses that phosphors can be uniformly dispersed in a two-liquid configuration, in which a phosphor dispersion liquid and a precursor solution are separately applied.

PTL 3 discloses that a low efficiency is overcome and color points are controlled by disposing a light scattering layer containing TiO₂ between a radiation source and an inorganic layer containing a light emitting material (ceramic material).

### Citation List

### Patent Literature

PTL 1
   Japanese Patent Application Laid-Open No. 2002-314142
PTL 2
   WO2012/023425
PTL 3
   Japanese Unexamined Patent Application Publication (Translation of PCT Application) No. 2009-549558

### Summary of Invention

### Technical Problem

However, when encapsulating an LED chip with a silicone resin as in PTL 1, an encapsulating material may be degraded by the light from the LED chip or the heat from the LED chip or a phosphor, and the material may be colored. Therefore, it was difficult to achieve sufficient durability for long-time use by encapsulating with a silicone resin.

As another way than the encapsulation by a silicon resin, the heat resistance or light resistance of an LED chip may be improved by encapsulating the LED chip with a ceramic. To form a ceramic layer, a solution containing a ceramic precursor and phosphor particles is necessary. With regards to the solution, it was found out that phosphor particles and a translucent ceramic material may react with each other in the solution, and thus partially the viscosity increases or the solution solidifies, and the solution cannot be applied, namely the shortening of pot life.

in view of the above, PTL 2 proposes that a phosphor dispersion liquid containing phosphor particles, and a precursor solution containing a translucent ceramic precursor (organometallic compound), are prepared and applied separately, and then the applied ceramic precursor is cured.

However, it was also found out that, even in the two-liquid configuration as in PTL 2 in which a phosphor dispersion liquid and precursor solution are separately prepared, phosphor particles in the phosphor dispersion liquid settle with time after mixing, and chromaticity unevenness may be generated after the applying.

In the present invention, LED devices including a wavelength conversion layer are provided, which have high durability and can suppress chromaticity variation (chromaticity variation among devices) and chromaticity unevenness (uniformity in one light emitting device). Also, a phosphor dispersion liquid for forming a wavelength conversion layer included in such LED devices is provided. Further, a method of manufacturing the LED device including forming an encapsulating film using the phosphor dispersion liquid is provided.

### Solution to Problem

A first aspect of the present invention relates to the following phosphor dispersion liquids.
[1] A phosphor dispersion liquid containing phosphor particles, light scattering microparticles, laminar clay mineral particles, silicon oxide particles and a solvent, wherein the light scattering microparticles content is 0.1 to 2.5mass% based on the phosphor particles in the phosphor dispersion liquid.
[2] The phosphor dispersion liquid according to [1], wherein the light scattering microparticles are made of a white pigment.
[3] The phosphor dispersion liquid according to [1] or [2], wherein the refractive index of the light scattering microparticles is 1.6 or more.
[4] The phosphor dispersion liquid according to any one of [1] to [3] having the viscosity of 80 to 1,000 mPa·s.
[5] The phosphor dispersion liquid according to any one of [1] to [4], wherein the solvent is an aliphatic alcohol.
   A second aspect of the present invention relates to the following LED devices.
[6] An LED device including an LED element and a wavelength conversion layer converting light from the LED element to light of another specific wavelength, wherein the wavelength conversion layer contains a ceramic, phosphor particles bound with the ceramic, light scattering microparticles, laminar clay mineral particles, and silicon oxide particles, wherein the light scattering microparticles content is 0.05 to 2mass% in the wavelength conversion layer.
[7] The LED device according to [6] further including a transparent resin layer disposed on the wavelength conversion layer.
   A third aspect of the present invention relates to the following methods of manufacturing an LED device.
[8] A method of manufacturing the LED device according to [6] or [7] including: preparing an LED element; applying the phosphor dispersion liquid according to any one of [1] to [5] on the LED element to form a phosphor layer; applying a translucent ceramic material composition including a translucent ceramic material and solvent on the phosphor layer; and curing the translucent ceramic material to form a wavelength conversion layer in which the phosphor layer is bound with a translucent ceramic.

### Advantageous Effects of Invention

By forming an encapsulating film (phosphor film) using the phosphor dispersion liquid of the present invention, an LED device can be provided in which chromaticity variation and chromaticity unevenness (uniformity in the surface of a light emitting device) are suppressed.

### Brief Description of Drawings

FIG. 1 illustrates an example of an LED device;
FIG. 2 illustrates another example of an LED device; and
FIG. 3 illustrates an example of a sprayer.

### Description of Embodiments

### 1. Phosphor Dispersion Liquid

A phosphor dispersion liquid of the present invention contains phosphor particles, light scattering microparticles, laminar clay mineral particles, silicon oxide particles, and a solvent. Further, in one use condition of the phosphor dispersion liquid, a translucent ceramic material is further contained.

### Phosphor Particles

It is sufficient that the phosphor particles are excited by light emitted by an LED chip to emanate fluorescence having a wavelength that is different from that of the light emitted by the LED chip. Examples of phosphor particles that emanate yellow fluorescence include yttrium-aluminum-garnet (YAG) phosphor. The YAG phosphor can emanate yellow fluorescence (550 to 650 nm wavelength) upon receipt of blue light (420 to 485 nm wavelength) emitted by blue LED chip 3.

The phosphor particles can be produced for example by a method including the steps of: 1) mixing an appropriate amount of flux (fluoride such as ammonium fluoride) with a mixed raw material having a predetermined composition followed by pressing to produce a molded article; and 2) loading the resulting molded article into a crucible followed by calcination in air at 1,350 to 1,450°C for 2 to 5 hours to produce a sintered product.

The mixed raw material having a predetermined composition can be produced by fully mixing oxides of Y, Gd, Ce, Sm, Al, La or Ga or compounds that are easily converted to the oxides at elevated temperatures, at stoichiometric ratios. The mixed raw material having a predetermined composition can also be produced by a method including the steps of: 1) mixing a solution containing the rare earth elements Y, Gd, Ce or Sm at stoichiometric ratios in acid with oxalic acid to provide a coprecipitate oxide; and 2) mixing the coprecipitate oxide with aluminum oxide or gallium oxide.

The phosphor is not limited to YAG phosphor; for example, other phosphors, including Ce-free non-garnet phosphor, can also be available.

The mean particle diameter of the phosphor particles is preferably 1 to 50 µm, and is more preferably 10 µm or less. The larger the particle diameter of the phosphor particles is, the higher luminescence efficiency (wavelength conversion efficiency) becomes. However, if the particle diameter of the phosphor particles is too large, the gaps caused between phosphor particles become larger in the resulting coating film of the phosphor dispersion liquid, and thereby the strength of the resulting phosphor particle layer may be lowered. The mean particle diameter of the phosphor particles can be measured, for example, by Coulter counter method.

The amount of the phosphor particles to be mixed into the phosphor dispersion liquid is preferably 10 to 99mass%, and more preferably 20 to 97mass% based on the total mass of the solid content of the phosphor dispersion liquid. If the concentration of the phosphor particles is less than 10mass%, sufficient fluorescence may not be obtained from the resulting coating film of the phosphor dispersion liquid. If the amount of the phosphor particles exceeds 99mass%, the amount of the laminar clay mineral particles or the amount of the silicon oxide particles is small relatively, and thus phosphor particles may settle in the phosphor dispersion liquid.

### Light Scattering Microparticles

Light scattering microparticles contained in the phosphor dispersion liquid is preferably a white pigment. Examples of the white pigments include calcium carbonate, magnesium carbonate, barium carbonate, magnesium sulfate, barium sulfate, calcium sulfate, zinc oxide, magnesium oxide, calcium oxide, titanium oxide, aluminum oxide, zirconium oxide, zinc sulfide, aluminum hydroxide, boron nitride, aluminum nitride, potassium titanate, barium titanate, aluminum titanate, strontium titanate, calcium titanate, magnesium titanate and hydroxyapatite. Among these, titanium oxide, aluminum oxide, zinc oxide and barium sulfate are preferable. The light scattering microparticles contains at least one or may contain a combination of the white pigments.

The refractive index of the light scattering microparticles is preferably 1.6 or more. Examples of white pigments having the refractive index of 1.6 or more include titanium oxide (2.52), aluminum oxide (1.76), zinc oxide (1.95) and barium sulfate (1.64).

The mean primary particle diameter of the phosphor particles is preferably more than 100 nm and 20 µm or less, more preferably more than 100 nm and 10 µm or less, and still more preferably more than 200 nm and 2.5 µm or less. The mean primary particle diameter of the present invention refers to a D50 value measured using a laser diffraction particle size analyzer. Examples of laser diffraction particle size analyzers include Laser Diffraction Particle Size Analyzer manufactured by Shimadzu Corporation.

The light scattering microparticles content in the phosphor dispersion liquid is preferably 0.1 to 2.5mass% based on the phosphor particles.

### Laminar Clay Mineral Particles

A laminar clay mineral particle contained in the phosphor dispersion liquid is a particle composed of a clay mineral having a laminar structure. The laminar clay mineral particle has a plate-like shape. Therefore, when laminar clay mineral particles are contained, the viscosity of the phosphor dispersion liquid is increased. Further, as mentioned above, the laminar clay mineral particles have a high affinity with phosphor particles. Accordingly, when the laminar clay mineral particles are uniformly dispersed in a first dispersion liquid, the dispersibility of the phosphor particles is increased.

Examples of the laminar clay minerals include laminar silicate minerals, imogolite, allophane, and the like. The laminar silicate mineral is preferably a swellable clay mineral having a mica structure, a kaolinite structure or a smectite structure, and particularly preferably a swellable clay mineral having a smectite structure for its good swelling property. Since the swellable clay mineral particles form a card-house structure in the phosphor dispersion liquid, the viscosity of the phosphor dispersion liquid is increased even when only a small amount of the particles is contained.

Specific examples of the laminar clay minerals include: smectite clay minerals such as hectorite, saponite, stevensite, beidellite, montmorillonite, nontronite, and bentonite; swellable mica clay minerals such as Na tetrasilicicfluorinemica, Li tetrasilicicfluorinemica, Na fluorine taeniolite and Li fluorine taeniolite; vermiculite; kaolinite; and mixtures thereof. Those mineral may be a natural material or a synthetic material.

Examples of commercially available laminar clay mineral particles include: Laponite XLG (synthetic hectorite analogue available from LaPorte Co., UK); Laponite RD (synthetic hectorite analogue available from LaPorte Co., UK); Samabisu (synthetic hectorite analogue available from Henkel, Germany); Sumecton SA-1 (saponite analogue available from KUNIMINE Industry Co., Ltd.); BEN-GEL (natural bentonite available from Hojun Corporation); Kunipia F (natural montmorillonite available from KUNIMINE Industry Co., Ltd.); Veegum (natural hectorite available from Vanderbilt Co., Ltd, US); Dimonite (synthetic swellable mica available from Topy Industries Ltd.); Somasif (synthetic swellable mica available from CO-OP CHEMICAL CO., LTD.); SWN (synthetic smectite available from CO-OP CHEMICAL CO., LTD.); and SWF (synthetic smectite available from CO-OP CHEMICAL CO., LTD.).

The laminar clay mineral particles may be those the surface of which is modified (surface-treated) with an ammonium salt or the like. When the surfaces of the laminar clay mineral particles are modified, the dispersibility of the laminar clay mineral particles in the phosphor dispersion liquid improves.

The mean particle diameter of the laminar clay mineral particles is preferably 0.1 to 100 µm, and more preferably 1 to 50µm. When the size of the laminar clay mineral particles is 0.1µm or greater, the aforementioned viscosity-improving effect can be easily obtained. On the other hand, if the size of the laminar clay mineral particles is greater than 100 µm, the light transmissivity of the final resulting coating film of phosphor particles may be lowered. The size of the laminar clay mineral particles is measured by Coulter counter method, or the like.

The amount of the laminar clay mineral particles in the phosphor dispersion liquid is preferably 0.1 to 5mass%, and more preferably 0.5 to 4mass% based on the total amount of the components other than the phosphor particles in the phosphor dispersion liquid. If the concentration of the laminar clay mineral particles is less than 0.1mass%, the viscosity of the phosphor dispersion liquid is not increased sufficiently. On the other hand, if the concentration of the laminar clay mineral particles exceeds 5mass%, the fluidity of the phosphor dispersion liquid may be lowered, causing the dispersibility of the phosphor particles to be lowered in the steps described later. Incidentally, it is not that, the more the ratio of the laminar clay mineral particles is increased, the more the viscosity of the phosphor dispersion liquid is increased. The viscosity of the phosphor dispersion liquid is determined depending on the content ratio of the laminar clay mineral particles relative to the amount of another component, such as a solvent, silicon oxide particles, or the like.

### Silicon Oxide Particles

The phosphor dispersion liquid contains silicon oxide particles. The refractive index of the silicon oxide particles (1.46) is close to that of a translucent ceramic material (e.g., the refractive index of polysiloxane is 1.41). Silicon oxide particles contained in the phosphor dispersion liquid can increase the viscosity of the phosphor dispersion liquid.

The mean primary particle diameter of the silicon oxide particles is preferably 5 to 100 nm, more preferably 5 to 80 nm, and still more preferably 5 to 50 nm. When the mean primary particle diameter of the silicon oxide particles is within these ranges, the viscosity of the first dispersion liquid can be easily increased. The mean primary particle diameter of the silicon oxide particles is measured by Coulter counter method.

The silicon oxide particles content in the phosphor dispersion liquid is preferably 1 to 40mass%, more preferably 1 to 20mass%, and still more preferably 1 to 10mass% based on the total amount of the components other than the phosphor particles in the phosphor dispersion liquid. If the amount of the silicon oxide particles is too small, the viscosity of the resulting phosphor dispersion liquid is not sufficiently increased. On the other hand, if the amount of the silicon oxide particles is too large, the amount of the laminar clay mineral particles is low relatively, and thus the phosphor particles may settle, or the dispersibility of the phosphor particles in the phosphor dispersion liquid may be lowered.

### Solvent

Solvents are not particularly limited, as long as laminar clay mineral particles, silicon oxide particles and light scattering microparticles can be dispersed. Examples of the solvents include water, organic solvents having good compatibility with water, and organic solvents with less compatibility with water. From the viewpoint of the dispersibility of laminar clay mineral particles, silicon oxide particles and light scattering microparticles, the viscosity of the resulting phosphor dispersion liquid, and the like, the solvent is preferably an aliphatic alcohol. The aliphatic alcohol may be a monovalent aliphatic alcohol, or may be a divalent or higher polyvalent aliphatic alcohol. In particular, it is preferable to combine a monovalent aliphatic alcohol and a polyvalent aliphatic alcohol, from the viewpoint of the viscosity of the resulting phosphor dispersion liquid.

When the phosphor dispersion liquid contains a monovalent aliphatic alcohol, the viscosity of the phosphor dispersion liquid may be easily lowered. Further, the drying property of the coating film of the phosphor dispersion liquid improves. Examples of the monovalent aliphatic alcohols include methanol, ethanol, propanol and butanol. The amount of the monovalent aliphatic alcohol in the phosphor dispersion liquid is preferably 10 to 50mass%, and more preferably 25 to 45mass% based on the total amount of the components other than the phosphor particles in the phosphor dispersion liquid.

On the other hand, when a polyvalent aliphatic alcohol is contained, the viscosity of the phosphor dispersion liquid may be easily increased. The polyvalent aliphatic alcohol may be either diol or triol. Examples of the polyvalent aliphatic alcohols include ethylene glycol, propylene glycol, diethylene glycol, glycerin, 1,3-butanediol and 1,4-butanediol, and preferably ethylene glycol, propylene glycol, 1,3-butanediol and 1,4-butanediol. The amount of the polyvalent alcohol in the phosphor dispersion liquid is preferably 40 to 80mass%, more preferably 50 to 70mass% based on the total amount of the components other than the phosphor particles in the phosphor dispersion liquid.

The solvent of the phosphor dispersion liquid may contain water. When water is contained, water enters between layers of swellable clay mineral particles which can be laminar clay mineral particles so that the swellable clay mineral particles swell, allowing the viscosity of the phosphor dispersion liquid to be increased more. However, if water contains impurities, the swelling of the swellable clay mineral particles may be inhibited. Thus, in the case of allowing the swellable clay mineral particles to swell, pure water is adopted as water to be mixed.

It is also preferable that the solvent of the phosphor dispersion liquid includes an organic solvent having a boiling point of 150°C or higher. When the organic solvent having a boiling point of 150°C or higher is contained, the storage stability of the final resulting phosphor dispersion liquid is improved. On the other hand, the boiling point of the solvent is preferably 250°C or lower. If the boiling point of the solvent exceeds 250 °C, it may be difficult to dry the solvent from the final resulting coating film of the phosphor dispersion liquid.

The total amount of the solvent in the phosphor dispersion liquid is preferably 55 to 99mass%, and more preferably 75 to 98mass% based on the total amount of the components other than the phosphor particles in the phosphor dispersion liquid. If the total amount of the solvent is less than 55mass%, the viscosity of the phosphor dispersion liquid becomes too high, and thus the phosphor particles may not be able to be dispersed uniformly in the steps described later. On the other hand, if the total amount of the solvent exceeds 99mass%, the amount of laminar clay mineral particles or oxide microparticles is small relatively, and the viscosity of the phosphor dispersion liquid is not increased sufficiently, so that the phosphor particles mixed in the steps described later may settle.

### Translucent Ceramic Material

The phosphor dispersion liquid may contain a translucent ceramic material. The translucent ceramic material may be a compound that becomes a translucent ceramic (preferably a glass ceramic) by a sol-gel reaction. Examples of the translucent ceramic material include metal alkoxides, metal acetylacetonates, metal carboxylates and polysilazane oligomers, with metal alkoxides being preferable from the viewpoint of excellent reactivity.

The metal alkoxides may be various metal alkoxides, but are preferably alkoxysilanes or aryloxysilanes from the viewpoint of the stability and manufacturing easiness of the resulting translucent ceramic.

The alkoxysilane or aryloxysilane may be a monomolecular compound (monomer) such as tetraethoxysilane, but is preferably a polysiloxane (oligomer). Polysiloxane is a compound obtained through linear or cyclic siloxane bonding of silane compounds. The preparation method of polysiloxane will be described later.

The mass mean molecular weight of polysiloxane is preferably 1,000 to 3,000, more preferably1,200 to 2,700, and still more preferably 1,500 to 2,000. If the mass mean molecular weight of polysiloxane is less than 1,000, the viscosity of the translucent ceramic material composition may be too low. On the other hand, if the mass mean molecular weight exceeds 3,000, the viscosity of the translucent ceramic material composition becomes higher, and it may be difficult to apply the translucent ceramic material composition. The mass mean molecular weight is a value measured by gel permeation chromatography (in terms of polystyrene).

Polysiloxane can be obtained by polymerizing an alkoxysilane compound or an aryloxysilane compound. The alkoxysilane compound or aryloxysilane compound is represented, for example, by the following general formula (I):

Si(OR)ₙY₄₋ₙ (I).

In the general formula (I), n represents the number of alkoxy groups or aryloxy groups (OR), and is an integer of 2 or more and 4 or less. R represents, each independently, an alkyl group or a phenyl group, and preferably represents an alkyl group having 1 to 5 carbon atoms, or a phenyl group.

In the aforementioned general formula (I), Y represents a hydrogen atom, or a monovalent organic group. Specific examples of the monovalent organic group represented by Y include an aliphatic group, an alicyclic group, an aromatic group, and an alicyclic aromatic group having 1 to 1,000, preferably 500 or less, more preferably 100 or less, still more preferably 50 or less, and particularly preferably 6 or less carbon atoms. The monovalent organic group may be a group in which an aliphatic group, an alicyclic group, an aromatic group, and/or an alicyclic aromatic group are linked via a linking group. The linking group may be an atom such as O, N or S, or an atomic group containing these atoms. The monovalent organic group represented by Y may have a substituent. Examples of the substituent include: halogen atoms such as F, Cl, Br and I; and organic functional groups such as a vinyl group, a methacryloxy group, an acryloxy group, a styryl group, a mercapto group, an epoxy group, an epoxycyclohexyl group, a glycidoxy group, an amino group, a cyano group, a nitro group, a sulfonate group, a carboxy group, a hydroxy group, an acyl group, an alkoxy group, an imino group, and a phenyl group.

In the general formula (I), it is preferable that a group represented by Y is particularly a methyl group. When Y is a methyl group, the light resistance and heat resistance of a wavelength conversion layer improve.

The alkoxysilane or aryloxysilane represented by the aforementioned general formula (I) may be the following tetrafunctional silane compounds, trifunctional silane compounds, and bifunctional silane compounds.

Examples of the tetrafunctional silane compounds include: tetraalkoxysilanes and tetraaryloxysilanes such as tetramethoxysilane, tetraethoxysilane, tetrapropoxysilane, tetrabutoxysilane, tetrapentyloxysilane, tetraphenyoxysilane, trimethoxymonoethoxysilane, dimethoxydiethoxysilane, triethoxymonomethoxysilane, trimethoxymonopropoxysilane, monomethoxytributoxysilane, monomethoxytripentyloxysilane, monomethoxytriphenyloxysilane, dimethoxydipropoxysilane, tripropoxymonomethoxysilane, trimethoxymonobutoxysilane, dimethoxydibutoxysilane, triethoxymonopropoxysilane, diethoxydipropoxysilane, tributoxymonopropoxysilane, dimethoxymonoethoxymonobutoxysilane, diethoxymonomethoxymonobutoxysilane, diethoxymonopropoxymonobutoxysilane, dipropoxymonomethoxymonoethoxysilane, dipropoxymonomethoxymonobutoxysilane, dipropoxymonoethoxymonobutoxysilane, dibutoxymonomethoxymonoethoxysilane, dibutoxymonoethoxymonopropoxysilane, and monomethoxymonoethoxymonopropoxymonobutoxysilane.

Among these, tetramethoxysilane and tetraethoxysilane are preferable Examples of the trifunctional silane compounds include: monohydrosilane compounds such as trimethoxysilane, triethoxysilane, tripropoxysilane, tripentyloxysilane, triphenyloxysilane, dimethoxymonoethoxysilane, diethoxymonomethoxysilane, dipropoxymonomethoxysilane, dipropoxymonoethoxysilane, dipentyloxylmonomethoxysilane, dipentyloxymonoethoxysilane, dipentyloxymonopropoxysilane, diphenyloxylmonomethoxysilane, diphenyloxymonoethoxysilane, diphenyloxymonopropoxysilane, methoxyethoxypropoxysilane, monopropoxydimethoxysilane, monopropoxydiethoxysilane, monobutoxydimethoxysilane, monopentyloxydiethoxysilane, and monophenyloxydiethoxysilane; monomethylsilane compounds such as methyltrimethoxysilane, methyltriethoxysilane, methyltripropoxysilane, methyltripentyloxysilane, methylmonomethoxydiethoxysilane, methylmonomethoxydipropoxysilane, methylmonomethoxydipentyloxysilane, methylmonomethoxydiphenyloxysilane, methylmethoxyethoxypropoxysilane, and methylmonomethoxymonoethoxymonobutoxysilane; monoethylsilane compounds such as ethyltrimethoxysilane, ethyltripropoxysilane, ethyltripentyloxysilane, ethyltriphenyloxysilane, ethylmonomethoxydiethoxysilane, ethylmonomethoxydipropoxysilane, ethylmonomethoxydipentyloxysilane, ethylmonomethoxydiphenyloxysilane, and ethylmonomethoxymonoethoxymonobutoxysilane; monopropylsilane compounds such as propyltrimethoxysilane, propyltriethoxysilane, propyltripentyloxysilane, propyltriphenyloxysilane, propylmonomethoxydiethoxysilane, propylmonomethoxydipropoxysilane, propylmonomethoxydipentyloxysilane, propylmonomethoxydiphenyloxysilane, propylmethoxyethoxypropoxysilane, and propylmonomethoxymonoethoxymonobutoxysilane; and monobutylsilane compounds such as butyltrimethoxysilane, butyltriethoxysilane, butyltripropoxysilane, butyltripentyloxysilane, butyltriphenyloxysilane, butylmonomethoxydiethoxysilane, butylmonomethoxydipropoxysilane, butylmonomethoxydipentyloxysilane, butylmonomethoxydiphenyloxysilane, butylmethoxyethoxypropoxysilane, and butylmonomethoxymonoethoxymonobutoxysilane. Among these, methyltrimethoxysilane and methyltriethoxysilane are preferable, and methyltrimethoxysilane is more preferable.

Specific examples of the bifunctional silane compounds include: dimethoxysilane, diethoxysilane, dipropoxysilane, dipentyloxysilane, diphenyloxysilane, methoxyethoxysilane, methoxypropoxysilane, methoxypentyloxysilane, methoxyphenyloxysilane, ethoxypropoxysilane, ethoxypentyloxysilane, ethoxyphenyloxysilane, methyldimethoxysilane, methylmethoxyethoxysilane, methyldiethoxysilane, methylmethoxypropoxysilane, methylmethoxypentyloxysilane, methylmethoxyphenyloxysilane, ethyldipropoxysilane, ethylmethoxypropoxysilane, ethyldipentyloxysilane, ethyldiphenyloxysilane, propyldimethoxysilane, propylmethoxyethoxysilane, propylethoxypropoxysilane, propyldiethoxysilane, propyldipentyloxysilane, propyldiphenyloxysilane, butyldimethoxysilane, butylmethoxyethoxysilane, butyldiethoxysilane, butylethoxypropoxysilane, butyldipropoxysilane, butylmethyldipentyloxysilane, butylmethyldiphenyloxysilane, dimethyldimethoxysilane, dimethylmethoxyethoxysilane, dimethyldiethoxysilane, dimethyldipentyloxysilane, dimethyldiphenyloxysilane, dimethylethoxypropoxysilane, dimethyldipropoxysilane, diethyldimethoxysilane, diethylmethoxypropoxysilane, diethyldiethoxysilane, diethylethoxypropoxysilane, dipropyldimethoxysilane, dipropyldiethoxysilane, dipropyldipentyloxysilane, dipropyldiphenyloxysilane, dibutyldimethoxysilane, dibutyldiethoxysilane, dibutyldipropoxysilane, dibutylmethoxypentyloxysilane, dibutylmethoxyphenyloxysilane, methylethyldimethoxysilane, methylethyldiethoxysilane, methylethyldipropoxysilane, methylethyldipentyloxysilane, methylethyldiphenyloxysilane, methylpropyldimethoxysilane, methylpropyldiethoxysilane, methylbutyldimethoxysilane, methylbutyldiethoxysilane, methylbutyldipropoxysilane, methylethylethoxypropoxysilane, ethylpropyldimethoxysilane, ethylpropylmethoxyethoxysilane, dipropyldimethoxysilane, dipropylmethoxyethoxysilane, propylbutyldimethoxysilane, propylbutyldiethoxysilane, dibutylmethoxyethoxysilane dibutylmethoxypropoxysilane and dibutylethoxypropoxysilane. Among these, dimethoxysilane, diethoxysilane, methyldimethoxysilane, and methyldiethoxysilane are preferable.

Polysiloxane is prepared by hydrolyzing the aforementioned silane compound in the presence of an acid catalyst, water, and an organic solvent, followed by a condensation reaction. The mass mean molecular weight of polysiloxane can be adjusted depending on reaction conditions (in particular, reaction time), or the like.

When preparing polysiloxane, a tetrafunctional silane compound and a trifunctional compound or a bifunctional compound may be mixed in advance at a desired molar ratio to polymerize them randomly. Alternatively, it may also be possible to polymerize a trifunctional silane compound or a bifunctional silane compound alone to some degree to obtain an oligomer, and then polymerize only a tetrafunctional silane compound with the oligomer or the like to obtain a block copolymer.

It is particularly preferable that the acid catalyst for the preparation of polysiloxane is an organic sulfonic acid represented by the following general formula (II):

R⁸-SO₃H (II).

In the aforementioned general formula (II), a hydrocarbon group represented by R⁸ is a linear, branched or cyclic, saturated or unsaturated hydrocarbon group having 1 to 20 carbon atoms. Examples of the cyclic hydrocarbon group include an aromatic hydrocarbon group such as a phenyl group, a naphthyl group, or an anthryl group, with a phenyl group being preferable. Further, the hydrocarbon group represented by R⁸ in the general formula (II) may have a substituent. Examples of the substituent include: a linear, branched or cyclic, saturated or unsaturated hydrocarbon group having 1 to 20 carbon atoms; halogen atoms such as a fluorine atom; a sulfonate group; a carboxyl group; a hydroxyl group; an amino group; and a cyano group.

The organic sulfonic acid represented by the aforementioned general formula (II) is particularly preferably nonafluorobutane sulfonic acid, methanesulfonic acid, trifluoromethane sulfonic acid, or dodecylbenzenesulfonic acid.

The amount of the acid catalyst to be added at the time of preparing polysiloxane is preferably 1 to 1,000 mass ppm, and more preferably 5 to 800 mass ppm based on the total amount of a polysiloxane preparation liquid.

Depending on the amount of water to be added at the time of preparing polysiloxane, the property of a calcined product of polysiloxane varies. Therefore, it is preferable to adjust water addition ratio at the time of preparing polysiloxane depending on a target property. The water addition ratio is a ratio (%) of the molar number of water molecules to be added, based on the molar number of alkoxy group or aryloxy group of a silane compound contained in a polysiloxane preparation liquid. The water addition ratio is preferably 50 to 200%, and more preferably 75 to 180%. By setting the water addition ratio to 50% or higher, the property of the wavelength conversion layer is stabilized. Further, by setting it to 200% or lower, the storage ability of the translucent ceramic material composition improves.

Examples of a solvent to be added at the time of preparing polysiloxane include: monovalent aliphatic alcohols such as methanol, ethanol, propanol, and n-butanol; alkylcarboxylic acid esters such as methyl-3-methoxy propionate, and ethyl-3-ethoxy propionate; polyvalent aliphatic alcohols such as ethylene glycol, diethylene glycol, propylene glycol, glycerin, trimethylolpropane, and hexanetriol; polyvalent aliphatic alcohol monoethers such as ethyleneglycol monomethylether, ethyleneglycol monoethylether, ethyleneglycol monopropylether, ethyleneglycol monobutylether, diethyleneglycol monomethylether, diethyleneglycol monoethylether, diethyleneglycol monopropylether, diethyleneglycol monobutylether, propyleneglycol monomethylether, propyleneglycol monoethylether, propyleneglycol monopropylether, and propyleneglycol monobutylether, or monoacetates thereof; esters such as methyl acetate, ethyl acetate, and butyl acetate; ketones such as acetone, methyl ethyl ketone, and methyl isoamyl ketone; and polyvalent alcohol ethers obtained by alkyl-etherifying all of hydroxyl groups of polyvalent alcohols such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether, and diethylene glycol methylethyl ether. One type of these may be added alone, or two or more types of these may be added.

When the phosphor dispersion liquid contains polysiloxane, the polysiloxane content in the phosphor dispersion liquid is preferably 1 to 10mass%.

The viscosity of the phosphor dispersion liquid is preferably typically 80 to 1,000 mPa·s, and more preferably 100 to 450 mPa·s, although the viscosity is determined appropriately depending on the application methods of the phosphor dispersion liquid. If the viscosity of the phosphor dispersion liquid is less than 80 mPa·s, the phosphor particles easily settle during storing of the phosphor dispersion liquid. On the other hand, if the viscosity exceeds 1,000mPa·s, the viscosity of the phosphor dispersion liquid is too high, and it may be difficult to apply the phosphor dispersion liquid. The viscosity of the phosphor dispersion liquid is adjusted by the stirring time for dispersing the phosphor particles, a shearing force at the time of dispersing, or the like. The aforementioned viscosity is a value measured one minute after a vibrator of a vibration-type viscosity measuring apparatus (VM-10A, available from SEKONIC CORPORATION) is immersed in the phosphor dispersion liquid of 25°C.

### 2. Preparation of Phosphor Dispersion Liquid

The phosphor dispersion liquid may be prepared by either: 1) preparing a mixture containing phosphor particles, laminar clay mineral particles, silicon oxide particles, light scattering microparticles and a solvent, and stirring the mixture altogether (batch method); or 2) stirring a mixture containing the components other than the phosphor particles and then mixing in the phosphor particles and stirring (sequential method).

### Batch Method

When stirring a mixture of the components contained in the phosphor dispersion liquid altogether, the mixture can be stirred and dispersed using stirring devices such as a stirrer mill, a blade kneader, or a thin-film spin dispersing machine. Specific examples of the stirring devices include: media-less stirring devices such as ULTRA-TURRAX (IKA Co., Ltd.), T.K. Auto Homomixer (PRIMIX Corporation), T.K. Pipeline Homomixer (PRIMIX Corporation), T.K. Fill Mix (PRIMIX Corporation), Cleamix (M Technique Co., Ltd.), Clea SS5 (M Technique Co., Ltd.), Cavitron (Eurotech Co., Ltd.), and Fine Flow Mill (Taiheiyo Kiko K.K.); media stirring devices such as Viscomill (Imex Co., Ltd.), Apex Mill (Kotobuki Industries Co., Ltd.), Star Mill (Ashizawa Fine Tech Co., Ltd.), DCP Super Flow (Nippon Eirich K.K.), MP Mill (Inoue, Ltd.), Spike Mill (Inoue, Ltd.), Mighty Mill (Inoue, Ltd.), and SC mill (Mitsui Kozan K.K.); and high-pressure atomizers such as Ultimizer (Sugino Machine K.K.), Nanomizer (Yoshida Kikai Co., Ltd.), and NANO3000 (Beryu Co., Ltd.). Further, preferable examples also include ultrasonic wave dispersion apparatuses.

### Sequential Method

When preparing the phosphor dispersion liquid by stirring a mixture containing the components other than the phosphor particles and then mixing in the phosphor particles and stirring, the phosphor dispersion liquid is prepared in the following steps.
Preparing First Dispersion Liquid: Preparing a first dispersion liquid by stirring a mixture containing laminar clay mineral particles, silicon oxide particles, light scattering microparticles and a solvent
Preparing Phosphor Dispersion Liquid: Preparing a phosphor dispersion liquid by mixing phosphor particles in the first dispersion liquid and stirring the mixture

### Preparing First Dispersion Liquid

In the step of preparing the first dispersion liquid, the first dispersion liquid is prepared by stirring a mixture containing laminar clay mineral particles, silicon oxide particles, light scattering microparticles and a solvent. The mixture may contain other additives as necessary.

The mixture containing the laminar clay mineral particles, silicon oxide particles, light scattering microparticles and solvent can be stirred with a strong shearing force. By applying a strong shearing force to the mixture, aggregated particles of the laminar clay mineral particles, silicon oxide particles and light scattering microparticles are crushed, allowing them to be dispersed more uniformly. The time for stirring the mixture is appropriately adjusted in accordance with the amount of the mixture and the stirring method.

When stirring the mixture while applying a shearing force, the mixture can be stirred and dispersed using stirring devices such as a stirrer mill, a blade kneader, or a thin-film spin dispersing machine. Specific examples of the stirring devices include: media-less stirring devices such as ULTRA-TURRAX (IKA Co., Ltd.), T.K. Auto Homomixer (PRIMIX Corporation), T.K. Pipeline Homomixer (PRIMIX Corporation), T.K. Fill Mix (PRIMIX Corporation), Cleamix (M Technique Co., Ltd.), Clea SS5 (M Technique Co., Ltd.), Cavitron (Eurotech Co., Ltd.), and Fine Flow Mill (Taiheiyo Kiko K.K.); media stirring devices such as Viscomill (Imex Co., Ltd.), Apex Mill (Kotobuki Industries Co., Ltd.), Star Mill (Ashizawa Fine Tech Co., Ltd.), DCP Super Flow (Nippon Eirich K.K.), MP Mill (Inoue, Ltd.), Spike Mill (Inoue, Ltd.), Mighty Mill (Inoue, Ltd.), and SC mill (Mitsui Kozan K.K.); and high-pressure atomizers such as Ultimizer (Sugino Machine K.K.), Nanomizer (Yoshida Kikai Co., Ltd.), and NANO3000 (Beryu Co., Ltd.). Further, preferable examples also include ultrasonic wave dispersion apparatuses.

The viscosity of the resulting first dispersion liquid is 30 to 500 mPa·s, and preferably 50 to 250 mPa·s. If the viscosity of the first dispersion liquid is less than 30 mPa·s, the phosphor particles to be mixed in the later-described step may easily settle. On the other hand, if the viscosity exceeds 500 mPa·s, the viscosity is too high, and thus the phosphor particles cannot easily dispersed uniformly. The viscosity of the first dispersion liquid is adjusted by the time for stirring (dispersing) the liquid mixture or a shearing force at the time of stirring (dispersing). When the shearing force at the time of stirring is made higher, the viscosity of the first dispersion liquid is easily increased. Further, in general, when the time for stirring (dispersing) is shorter, the viscosity of the first dispersion liquid is likely to be lowered. The aforementioned viscosity is a value measured one minute after a vibrator of a vibration-type viscosity measuring apparatus (VM-10A, available from SEKONIC CORPORATION) is immersed in the phosphor dispersion liquid of 25°C

### Preparing Phosphor Dispersion Liquid

In the step of preparing the phosphor dispersion liquid, a mixture of the phosphor particles and the first dispersion liquid prepared in the aforementioned step is stirred, thereby dispersing the phosphor particles to obtain the phosphor dispersion liquid.

The mixture of the phosphor particles and the first dispersion liquid is preferably stirred without applying a strong shearing force to the mixture. As described above, the laminar clay mineral particles are dispersed uniformly in the first dispersion liquid. Therefore, even without a strong shearing force being applied, the affinity between the laminar clay mineral particles and the phosphor particles allows the phosphor particles to be easily dispersed uniformly. Further, since the laminar clay mineral particles and the phosphor particles are dispersed uniformly in the phosphor dispersion liquid, the phosphor particles do not settle easily.

Examples of the devices capable of stirring the mixture of the phosphor particles and the first dispersion liquid include a rotation/revolution stirrer, a vibration stirrer, a tumbler rotary stirrer, a container rotary mixer and a shaker. Specific examples of the stirring devices include a rotation/revolution stirrer: Awatori Rentaro (available from THINKY), vibration stirrers: Rocking Shaker (available from Seiwa Giken Co., Ltd.), and Rocking Mill (available from Seiwa Giken Co., Ltd.), a tumbler rotary stirrer: Mix Rotor (available from AS ONE Corporation), container rotary mixers: V-type Blender (available from Nishimura Machine Works Co., Ltd.), and Rocking Mixer (available from Aichi Electric Co., Ltd.) and a shaker: Shaking Incubator (available from AS ONE Corporation).

The time for stirring the mixture of the phosphor particles and the first dispersion liquid is preferably 1 to 30 minutes, and more preferably 5 to 15 minutes. If the stirring time is excessively long, the phosphor particles may be degraded. On the other hand, when the stirring time is excessively short, the phosphor particles may not be uniformly dispersed.

### 3. LED Device

An LED device of the present invention has an LED element that emits light of specific wavelength, and a wavelength conversion layer that is formed on the LED element and converts the light from the LED element to light of another specific wavelength. On the wavelength conversion layer, an arbitrary layer such as a transparent resin layer may be formed.

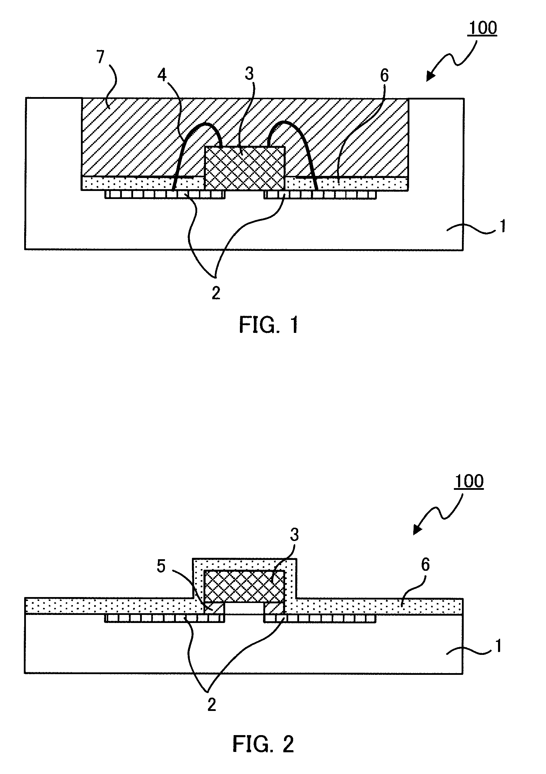

FIGS. 1 and 2 are sectional views illustrating examples of LED device 100. The LED device illustrated in FIG. 1 includes an LED element having LED chip 3, wavelength conversion layer 6 formed on the LED chip, and transparent resin layer 7.

### (1) LED Element

An LED chip in LED device 100 illustrated in FIG. 1 has package (LED substrate) 1, metal parts 2, LED chip 3, and interconnections 4 that connect metal parts 2 and LED chip 3.

While package 1 can be made, for example, of a liquid crystal polymer or a ceramic, the material thereof is not particularly limited as long as it has an insulating property and heat resistance. Also, the shape thereof is not particularly limited, for example, it may have a recess as illustrated in FIG. 1, or it may have a flat shape as illustrated in FIG. 2.

The luminescence wavelength of LED chip 3 is not particularly limited. LED chip 3 may emanate, for example, blue light (a light of about 420 to 485 nm), and may emanate ultraviolet light.

The configuration of LED chip 3 is not particularly limited. When the luminescent color of LED chip 3 is blue, LED chip 3 can be a laminate of an n-GaN compound semiconductor layer (cladding layer), an InGaN compound semiconductor layer (light emitting layer), a p-GaN compound semiconductor layer (cladding layer), and a transparent electrode layer. LED chip 3 can have an emission surface of 200 to 300 µm × 200 to 300 µm, for example. LED chip 3 typically has a height of about 50 to 200 µm.

Metal part 2 can be an interconnection made of metal such as silver. In the LED element, metal part 2 may function as a reflection plate that reflects light emitted by LED chip 3, or the like. Metal parts 2 and LED chip 3 may be connected to each other through interconnections 4 as illustrated in FIG. 1, or may be connected to each other through bump electrodes 5 as illustrated in FIG. 2. The mode in which metal parts 2 and LED chip 3 are connected through interconnections 4 is called wire-bonding, and the mode in which they are connected through bump electrodes 5 is called flip-chip bonding.

LED device 100 illustrated in FIGS. 1 and 2 only has one LED chip 3 being disposed in package 1; however a plurality of LED chips 3 may also be disposed in package 1.

### (2) Wavelength Conversion Layer

Wavelength conversion layer 6 includes a ceramic, phosphor particles bound with the ceramic, light scattering microparticles, laminar clay mineral particles and silicon oxide particles.

Wavelength conversion layer 6, upon receipt of a specific wavelength light (excitation light) emitted by LED chip 3, emanates another specific wavelength light (fluorescence). Mixing of excitation light with fluorescence allows the light from LED device 100 to be desired light. For example, when the light emitted by LED chip 3 is blue and the fluorescence emanated by phosphor particles contained in wavelength conversion layer 6 is yellow or orange, the light from LED device 100 becomes white.

It is sufficient that wavelength conversion layer 6 covers the emission surface of LED chip 3, and it is not necessary that it thoroughly covers package 1, metal parts 2, interconnections 4, or the like. While the thickness of wavelength conversion layer 6 is not particularly limited, the thickness is preferably typically 15 to 300 µm, and more preferably 30 to 200 µm. If the thickness of wavelength conversion layer 6 is too large, a crack may occur in wavelength conversion layer 6. On the other hand, if the thickness of wavelength conversion layer 6 is too small, sufficient phosphor particles may not be contained in wavelength conversion layer 6, resulting in sufficient fluorescence not being obtained. The thickness of wavelength conversion layer 6 means the maximum thickness of wavelength conversion layer 6 formed on the emission surface of LED chip 3. The thickness of wavelength conversion layer 6 is measured with a laser holographic gauge.

Since wavelength conversion layer 6 contains 0.05 to 2mass% light scattering microparticles, wavelength conversion layer 6 diffuses exciting light from the LED element and fluorescence from the phosphor. As a result, light emitted from the LED device is averaged, and chromaticity unevenness of the emitted light is reduced.

Wavelength conversion layer 6 preferably contains 5 to 20mass% ceramic, and the ceramic content is preferably 7 to 25mass% based on the phosphor particles to sufficiently bind the phosphor particles.

### (3) Transparent Resin Layer

Transparent resin layer 7 is formed so as to cover wavelength conversion layer 6. Transparent resin layer 7 protects the LED element or wavelength conversion layer 6 from the outer impact, gas, or the like. Further, when wavelength conversion layer 6 is included, a light coupling-out efficiency is also easily increased. The transparent resin layer contains a transparent resin and has high transparency to visible light.

Examples of the transparent resin include: silicone resins such as epoxy-modified silicone resins, alkyd-modified silicone resins, acryl-modified silicone resins, polyester-modified silicone resins, and phenyl silicone resins; epoxy resins; acryl resins; methacryl resins; and urethane resins. In particular, phenyl silicone resins are preferable. When the transparent resin is phenyl silicone resin, the wet resistance of the LED device is increased.

While the thickness of transparent resin layer 7 is not particularly limited, it is preferably typically 25 µm to 5 mm, and more preferably 1 to 3 mm. Generally, it is difficult to set the thickness of transparent resin layer 7 to 25 µm. On the other hand, from the viewpoint of downsizing the LED device, the thickness of transparent resin layer 7 is preferably 5 mm or less.

### 4. Method of Manufacturing LED Device

The method of manufacturing LED device can be classified into two types, two-liquid method and one-liquid method, according to the type of the phosphor dispersion liquid. The two-liquid method includes forming a wavelength conversion layer using a phosphor dispersion liquid including phosphor particles but not including a translucent ceramic material, and a translucent ceramic material composition including a translucent ceramic material. The one-liquid method includes forming a wavelength conversion layer using a phosphor dispersion liquid including a translucent ceramic material and phosphor particles.

The two-liquid method for manufacturing an LED device of the present invention includes steps of: 1) preparing an LED element; 2) applying a phosphor dispersion liquid on the LED element to form a phosphor particle layer; 3) applying a translucent ceramic material composition including a translucent ceramic material and solvent on the phosphor particle layer; and 4) curing the translucent ceramic material.

The one-liquid method for manufacturing an LED device of the present invention includes steps of: 1) preparing an LED element; 2) applying a phosphor dispersion liquid on the LED element to form a ceramic material layer; and 3) curing a translucent ceramic material to turn the ceramic material layer into a wavelength conversion layer.

The LED element is provided by electrically connecting metal parts formed in a package with an LED chip thereby fixing the LED chip to the package, and the like.

### Applying Phosphor Dispersion Liquid

The aforementioned phosphor dispersion liquid is applied so as to cover the emission surface of the LED chip to form a phosphor particle layer on the LED element. The phosphor dispersion liquid may be applied not only on the emission surface of the LED chip but also on the metal parts (metal interconnections) or the like of the LED element.

The means for application of the phosphor dispersion liquid is not particularly limited. Examples of the methods of applying the phosphor dispersion liquid include conventionally known methods such as bar-coating method, spin coating method, spray coating method, dispensing method, and jet-dispensing method. When the phosphor dispersion liquid is applied with a later-described spray applicator, or the like, the thickness of the phosphor particle layer can be made smaller.

The amount of application of the phosphor-containing composition is appropriately adjusted depending on the thickness of the phosphor particle layer. The thickness of the phosphor particle layer is preferably 15 to 300 µm, and more preferably 30 to 200 µm. If the thickness of the phosphor particle layer is less than 15 µm, the amount of the phosphor particles may become smaller, resulting in sufficient fluorescence not being obtained. On the other hand, if the thickness of the phosphor particle layer exceeds 300 µm, the concentration of the phosphor particles in the phosphor particle layer becomes excessively low, and thus the concentration of the phosphor particles may not be uniform. The thickness of the phosphor particle layer means the maximum thickness of the phosphor particle layer formed on the emission surface of the LED chip. The thickness of the phosphor particle layer is measured with a laser holographic gauge.

The solvent in the phosphor dispersion liquid is preferably dried after application of the phosphor dispersion liquid. The temperature when drying the solvent in the phosphor dispersion liquid is typically 20 to 200°C, and preferably 25 to 150°C. If the temperature is lower than 20°C, the solvent may not be sufficiently volatilized. On the other hand, if the temperature exceeds 200°C, it may adversely affect the LED chip. In addition, the drying time is typically 0.1 to 30 minutes, and preferably 0.1 to 15 minutes, from the viewpoint of manufacturing efficiency.

### - Spray Applicator for Phosphor Dispersion Liquid

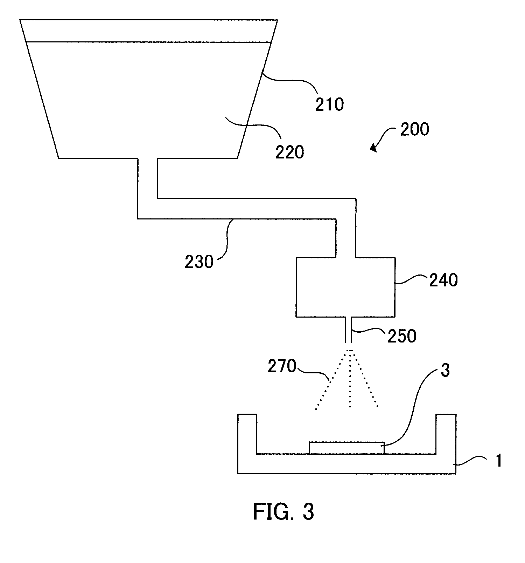

The spray applicator preferably includes a coating liquid tank that retains a phosphor dispersion liquid, a head having a nozzle for discharging a coating liquid, and a connector tube that allows fluid communication between the coating liquid tank and the nozzle. FIG. 3 illustrates the outline of the spray applicator for applying the coating liquid.

The phosphor dispersion liquid is loaded into coating liquid tank 210 in applicator 200 illustrated in FIG. 3. Phosphor dispersion liquid 220 inside coating liquid tank 210 in applicator 200 illustrated in FIG. 3 is pressurized and supplied to head 240 through connector tube 230. Phosphor dispersion liquid 220 supplied to head 240 is discharged from nozzle 250 as discharged liquid 270, and is applied to the coating target (LED chip 3). In the case of a spray applicator, discharging the coating liquid from nozzle 250 is carried out by means of wind pressure. Nozzle 250 may be configured to have an openable and closable port at the tip thereof, so that ON/OFF of the discharging operation is controlled by opening or closing the port.

In the step of applying the phosphor dispersion liquid, operations and condition settings of the following (1) to (9) are carried out.
(1) Basically, the tip of nozzle 250 is disposed immediately above LED chip 3 to spray phosphor dispersion liquid 220 from immediately above LED chip 3. In accordance with the shape of LED chip 3, phosphor dispersion liquid 220 may be sprayed from immediately above LED chip 3, or may be sprayed from diagonally above LED chip 3. Spraying from diagonally above LED chip 3 enables phosphor dispersion liquid 220 to be adequately applied to the entire surface of LED chip 3. It is preferable to uniformly apply phosphor dispersion liquid 220 also to the lateral surface of LED chip 3 in this manner.
(2) The spraying amount of phosphor dispersion liquid 220 is made constant, and the amount of phosphors per unit area is made constant. The variation of the spraying amount of phosphor dispersion liquid 220 over time is set to be within 10%, and preferably within 1%.
(3) The temperature of nozzle 250 is adjusted, and the viscosity of phosphor dispersion liquid 220 at the time of spraying is adjusted. Preferably, the temperature of phosphor dispersion liquid 220 is adjusted to be 40°C or lower, or is adjusted in accordance with the viscosity of phosphor dispersion liquid 220. In this case, LED substrate (package) 1 of the LED element may be placed under room temperature environment, or the temperature of LED substrate 1 of the LED element may also be controlled by providing a temperature adjusting mechanism on a moving table. When the temperature of LED substrate 1 is set higher at 30 to 100°C, an organic solvent in phosphor dispersion liquid 220 sprayed to LED substrate 1 can be volatilized quickly, enabling to prevent phosphor dispersion liquid 220 from dripping from LED substrate 1. Conversely, when the temperature of LED substrate 1 is set lower at 5 to 20°C, the solvent can be volatilized slowly, enabling phosphor dispersion liquid 220 to be uniformly applied along the outer wall of LED chip 3. Thus, the film density, the film strength and the like of the phosphor particle layer can be enhanced, enabling to form a dense film.
(4) The environmental atmosphere (temperature/humidity) of applicator 200 is made constant to stabilize the spraying of phosphor dispersion liquid 220.
(5) A mask may be disposed between applicator 200 and the LED element in accordance with the shape of LED chip 3 to spray phosphor dispersion liquid 220 via the mask. For the mask, it is necessary to use a material not dissolving into a solvent constituting phosphor dispersion liquid 220; from the viewpoint of collecting materials such as phosphors adhering to the mask, combustible one is preferably used.
(6) When the spraying and application of phosphor dispersion liquid 220 to one LED element is completed, the operation similar to the above is repeated for the following LED element, to sequentially spray and apply phosphor dispersion liquid 220 onto LED chip 3 of a plurality of LED elements. Phosphor dispersion liquid 220 may be continuously sprayed regardless of switching of LED elements, or the spraying of phosphor dispersion liquid 220 may be temporarily suspended for every switching of the LED elements to spray phosphor dispersion liquid 220 intermittently. When phosphor dispersion liquid 220 is continuously sprayed, the spraying amount of phosphor dispersion liquid 220 for each LED element can be stabilized. When phosphor dispersion liquid 220 is sprayed intermittently, the usage of phosphor dispersion liquid 220 can be saved.
(7) During the steps of spraying/application, for each time when the spraying and application of phosphor dispersion liquid 220 to a certain number of LED elements are completed, the chromaticity and luminance of white light may be actually inspected, to feed back the inspection results to the spraying amount, spraying pressure, spraying temperature, and the like of phosphor dispersion liquid 220.
(8) During the steps of spraying/application, nozzle 250 may be cleaned. In this case, a cleaning tank in which a cleaning liquid is retained is disposed in the vicinity of sprayer 200, and the tip of nozzle 250 is immersed in the cleaning tank during suspension of the spraying of phosphor dispersion liquid 220 or during inspection of the chromaticity and luminance of white light, to prevent the tip of nozzle 250 from being dried. In addition, during suspension of the steps of spraying and application, phosphor dispersion liquid 220 may be cured to cause a spraying port of nozzle 250 to be clogged, and thus it is preferable that nozzle 250 is immersed in the cleaning tank, or nozzle 250 is cleaned at the time of initiating the steps of spraying and application.
(9) In the steps of spraying and application, phosphor dispersion liquid 220 is sprayed in the form of mist, and thus, when an organic solvent in phosphor dispersion liquid 220 is volatilized, powder such as phosphor particles or oxide microparticles may be scattered. Therefore, spraying/application steps and inspection steps are carried out preferably while collecting dust and discharging air through a filter with applicator 200 being entirely covered with a housing or the like. If phosphor particles are trapped with a filter, expensive phosphor particles can be reused.

### Applying Translucent Ceramic Material Composition

The two-liquid manufacturing method includes applying the translucent ceramic material composition so as to cover the phosphor particle layer. The translucent ceramic material composition enters gaps in the phosphor particle layer to fill the gaps of phosphor particles, laminar clay mineral particles, silicon oxide particles, and the like contained in the phosphor particle layer.

### - Applying Translucent Ceramic Material Composition

The method of applying the translucent ceramic material composition is not particularly limited. Examples of the methods may be blade application, spin coating application, dispenser application, and spray application; according to the spray application, it is possible to form a wavelength conversion layer with smaller thickness. The spray applicator may be similar to the spray applicator to be used for the application of the aforementioned phosphor dispersion liquid.

The amount of application of the translucent ceramic material composition is set to be enough amount to sufficiently bind the phosphor particles, laminar clay mineral particles, silicon oxide particles, and the like in the phosphor particle layer. If the amount of application of the translucent ceramic material composition is too small, the phosphor particles cannot be sufficiently bound and therefore the strength of the wavelength conversion layer may be lowered.

The translucent ceramic material composition contains a translucent ceramic material and solvent, and further contains inorganic oxide particles and the like as necessary. The translucent ceramic material is similar to the translucent ceramic material which may be contained in the phosphor dispersion liquid, and may be polysiloxane or the like.

When the translucent ceramic material is polysiloxane, the amount of polysiloxane contained in the translucent ceramic material composition is preferably 1 to 40mass%, and more preferably 2 to 30mass% based on the total mass of the translucent ceramic material composition. If the amount of polysiloxane is less than 1 mass%, a cured product of polysiloxane may not be able to sufficiently bind phosphor particles and the like. On the other hand, if the amount of polysiloxane exceeds 40mass%, the viscosity of the translucent ceramic material composition becomes excessively high, and it may be difficult to apply the translucent ceramic material composition.

The translucent ceramic material composition may contain inorganic oxide particles. When inorganic oxide particles are contained in the translucent ceramic material composition, at the time when the translucent ceramic material composition is cured, a stress occurring on the film is alleviated, and therefore a crack is not easily generated in the wavelength conversion layer.

It is sufficient that the solvent contained in the translucent ceramic material composition can dissolve or uniformly disperse the aforementioned translucent ceramic material. Examples of the solvent include: monovalent aliphatic alcohols such as methanol, ethanol, propanol, and n-butanol; alkyl carboxylic acid esters such as methyl-3-methoxy propionate, and ethyl-3-ethoxy propionate; polyvalent aliphatic alcohols such as ethylene glycol, diethylene glycol, propylene glycol, glycerin, trimethylol propane, and hexane triol; polyvalent aliphatic alcohol monoethers such as ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, propylene glycol monomethyl ether, propylene glycol monoethyl ether, propylene glycol monopropyl ether, and propylene glycol monobutyl ether, or monoacetates thereof; polyvalent alcohol ethers obtained by alkyl-etherifying all of hydroxyl groups of polyvalent aliphatic alcohols such as ethylene glycol dimethyl ether, ethylene glycol diethyl ether, ethylene glycol dipropyl ether, ethylene glycol dibutyl ether, propylene glycol dimethyl ether, propylene glycol diethyl ether, diethylene glycol dimethyl ether, diethylene glycol diethyl ether, and diethylene glycol methylethyl ether; esters such as methyl acetate, ethyl acetate, and butyl acetate; and ketones such as acetone, methyl ethyl ketone, and methyl isoamyl ketone. Only one type of solvent or two or more types of solvents may be contained in the translucent ceramic material composition.

It is preferable that the solvent include water. The amount of water is preferably 3 to 15mass%, and more preferably 5 to 10mass% based on the total mass of the translucent ceramic material composition. When the translucent ceramic material is polysiloxane, the water content is preferably 10 to 120 mass parts, and more preferably 80 to 100 mass parts based on 100 mass parts of polysiloxane. If the amount of water contained in the translucent ceramic material composition is too small, polysiloxane may not be sufficiently hydrolyzed after application of the translucent ceramic material. On the other hand, if the amount of water contained in the translucent ceramic material composition is excessive, hydrolysis, or the like may occur during storing of the translucent ceramic material composition, causing the translucent ceramic material composition to be gelated.

It is also preferable that the solvents include organic solvents (e.g., ethylene glycol, propylene glycol) having a boiling point of 150°C or higher. When an organic solvent having a boiling point of 150°C or higher is contained, the storage stability of the translucent ceramic material composition is increased. Further, the solvent does not easily volatilize in the applicator, and thus the translucent ceramic material composition can be stably applied from the applicator.

On the other hand, the boiling point of the solvent contained in the translucent ceramic material composition is preferably 250°C or lower. If the boiling point of the solvent exceeds 250°C, it may take time to dry the translucent ceramic material composition, or that the solvent may not be dried sufficiently.

The translucent ceramic material contained in the phosphor dispersion liquid (one-liquid method) or the translucent ceramic material contained in the translucent ceramic material composition (two-liquid method) is dried and cured. By curing the translucent ceramic material, a wavelength conversion layer can be obtained, in which a phosphor particle layer is bound with the translucent ceramic material.

The method of drying and curing the translucent ceramic material is appropriately selected depending on the types of the translucent ceramic material. For example, when the translucent ceramic material is polysiloxane, a coating film is heated preferably to 100°C or higher, and is heated more preferably to 150 to 300°C. In the case where the translucent ceramic material is polysiloxane, if the heating temperature is lower than 100°C, the moisture occurring at the time of dehydration condensation cannot be sufficiently removed, and thus the light resistance of the wavelength conversion layer may be lowered.

Either two-liquid manufacturing method or one-liquid manufacturing method may include applying a composition for a transparent resin layer on the wavelength conversion layer to form a transparent resin layer. The composition for the transparent resin layer contains a transparent resin and as necessary a solvent. The transparent resin may be a curable resin transparent to visible light, or the like. The type of the solvent is appropriately selected depending on the type of the transparent resin or the viscosity of the composition for the transparent resin layer.

The method of application of the composition for the transparent resin layer is not particularly limited, and, for example, an application method using a general applicator such as a dispenser can be adopted. Further, the curing method and the curing condition of the composition for the transparent resin layer are appropriately selected depending on the types of the transparent resin. One example of the curing method is thermal curing.

### Examples

### 1. Preparation of Phosphor Dispersion Liquid

The following phosphor dispersion liquids of samples 1 to 13 are prepared. The viscosity of the phosphor dispersion liquids prepared in the samples 1 to 13 is measured one minute after a vibrator of a vibration-type viscosity measuring apparatus VM-10A (available from SEKONIC CORPORATION) is immersed in the phosphor dispersion liquid. The measurement results are shown in Table 1.

### Sample 1

3 g of BEN-GEL (available from Hojun Corporation: natural bentonite) as laminar clay mineral particles and 4.5 g of SILYSIA 470 (available from Fuji Silysia Chemical Ltd.) as silicon oxide particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 2

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, and 0.6 g of titanium oxide particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 3

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, and 2.2 g of titanium oxide particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 4

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, 0.8 g of aluminum oxide particles, 0.8 g of titanium oxide particles and 90 g of phosphor particles were added into a mixed solvent of 70 g of propylene glycol, 30 g of 1,3-butanediol and 50 g of isopropyl alcohol. The liquid mixture was dispersed altogether using TK Auto Homomixer (available from PRIMIX Corporation) to obtain a phosphor dispersion liquid. The viscosity of the obtained phosphor dispersion liquid was 400 mPa·s.

### Sample 5

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, and 1 g of zinc oxide particles were added into a mixed solvent of 70 g of propylene glycol, 30 g of 1,3-butanediol and 50 g of isopropyl alcohol. The liquid mixture was mixed using T.K. Fill Mix (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 6

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, and 0.1 g of barium sulfate particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 7

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, and 2.4 g of titanium oxide particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 8

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, and 3.5 g of barium sulfate particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 9

2.5 g of Micromica MK-100 (available from CO-OP CHEMICAL Co., Ltd.: synthetic mica) as laminar clay mineral particles, 4 g of AEROSIL RX300 (available from Nippon Aerosil Co., Ltd.) as silicon oxide particles, and 0.4 g of zinc oxide particles were added into a mixed solvent of 90 g of 1,3-butanediol and 60 g of isopropyl alcohol. The liquid mixture was mixed using Apex Mill (Kotobuki Industries Co., Ltd.) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 350 mPa·s.

### Sample 10

3 g of Lucentite SWN (available from CO-OP CHEMICAL CO., LTD.: smectite) as laminar clay mineral particles, 4 g of Microbead SP-1 (available from JGC Catalysts and Chemicals Ltd.) as silicon oxide particles, and 1.3 g of barium sulfate particles were added into a mixed solvent of 90 g of 1,3-butanediol, 30 g of isopropyl alcohol and 30 g of ethanol. The liquid mixture was mixed using Nanomizer (Yoshida Kikai Co., Ltd.) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 250 mPa·s.

### Sample 11

3 g of BEN-GEL (available from Hojun Corporation: natural bentonite) as laminar clay mineral particles, 4.5 g of SILYSIA 470 (available from Fuji Silysia Chemical Ltd.) as silicon oxide particles, and 1.5 g of calcium carbonate particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 200 mPa·s.

### Sample 12

2 g of BEN-GEL (available from Hojun Corporation: natural bentonite) as laminar clay mineral particles, 2 g of SILYSIA 470 (available from Fuji Silysia Chemical Ltd.) as silicon oxide particles, 0.8 g of aluminum oxide particles and 0.8 g of titanium oxide particles were added into a mixed solvent of 70 g of propylene glycol, 30 g of 1,3-butanediol and 50 g of isopropyl alcohol. The liquid mixture was mixed using TK Auto Homomixer (available from PRIMIX Corporation) to obtain a first dispersion liquid.

Subsequently, 90 g of phosphor particles were added to the first dispersion liquid. The mixture was stirred and mixed using Awatori Rentaro (available from THINKY) to obtain a phosphor dispersion liquid. The viscosity of the obtained phosphor dispersion liquid was 70 mPa·s.

### Sample 13

5 g of BEN-GEL (available from Hojun Corporation: natural bentonite) as laminar clay mineral particles, 8 g of SILYSIA 470 (available from Fuji Silysia Chemical Ltd.) as silicon oxide particles, 0.8 g of aluminum oxide particles, 0.8g of titanium oxide particles and 90 g of phosphor particles were added into a mixed solvent of 70 g of propylene glycol, 30 g of 1,3-butanediol and 50 g of isopropyl alcohol. The liquid mixture was dispersed altogether using Apex Mill (Kotobuki Industries Co., Ltd.) to obtain a first dispersion liquid. The viscosity of the obtained phosphor dispersion liquid was 1050 mPa·s.

A translucent ceramic material composition was prepared by mixing 15 mass parts of tetramethoxysilane KBM04 (available from Shin-Etsu Chemical Co., Ltd.), 5 mass parts of methyltrimethoxysilane KBM13 (available from Shin-Etsu Chemical Co., Ltd.), 40 mass parts of isopropyl alcohol, 40 mass parts of ethanol, and 2 mass parts of hydrochloric acid.

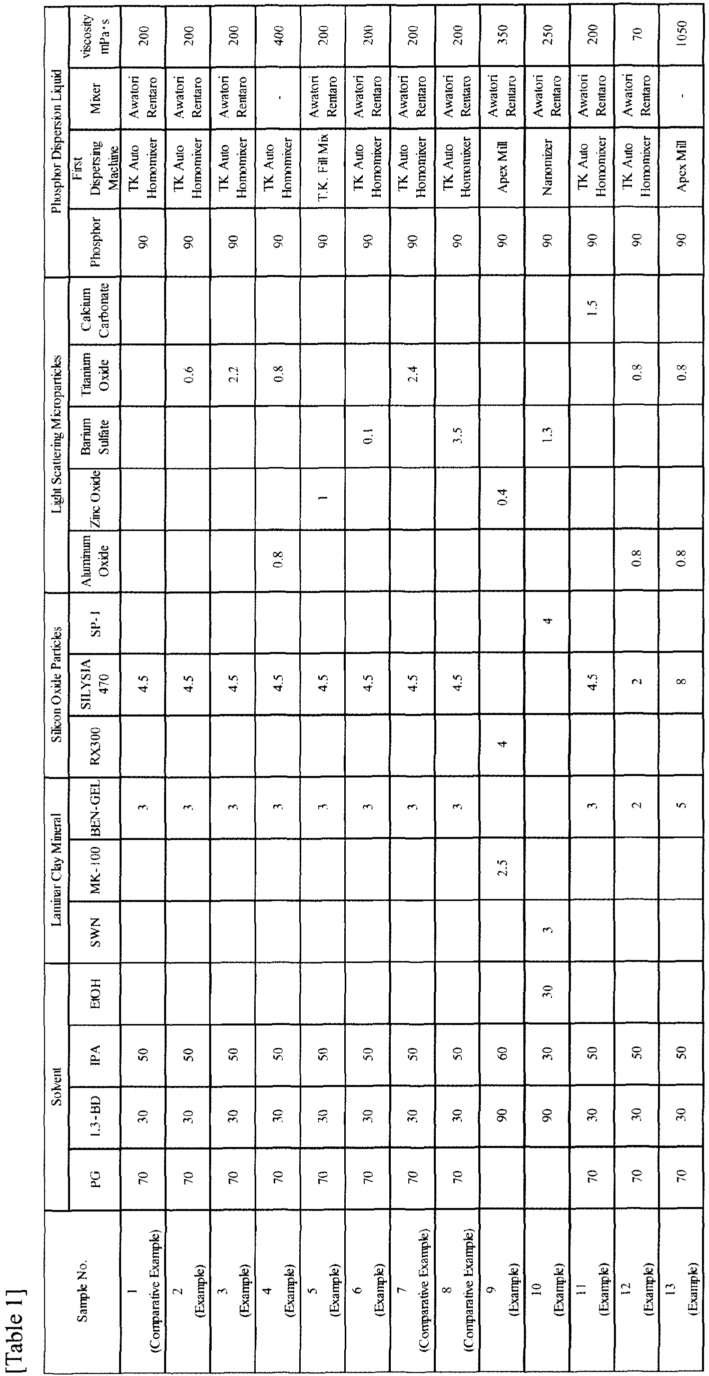

### (Manufacture of LED Device)

The phosphor dispersion liquids prepared in Samples 1 to 13 were applied to the inside of the recess of the LED element illustrated in FIG. 1 using a spray applicator. The conditions for the spray application were set such that the spraying pressure was 0.2 MPa and the relative movement speed between the spray nozzle and the emitting light element of the LED element was 100 mm/s. After the application of the phosphor dispersion liquid, heating was carried out at 150°C for 1 hour to form a phosphor layer.

Subsequently, a translucent ceramic material composition was prepared and spray-applied onto the phosphor layer so that 10mass% of the translucent ceramic material composition is contained in the phosphor layer (wavelength conversion layer). The conditions for the spray application were set such that the spraying pressure was 0.1 MPa and the relative movement speed between the spray nozzle and the emitting light element of the LED element was 100 mm/s. After the application of the translucent ceramic material composition, heating was carried out at 150°C for 1 hour to obtain a wavelength conversion layer with the phosphor layer being bound thereto with a translucent ceramic.

Further, phenyl silicone (available from Shin-Etsu Chemical Co., Ltd.; KER-6000) was applied onto the wavelength conversion layer with a dispenser, and heating was carried out at 150°C for 1 hour. Thereby, a transparent resin layer with a thickness of 2 mm was formed.

The LED devices manufactured in samples 1 to 13 were evaluated for a chromaticity variation among light emitting devices, a chromaticity variation in one light emitting device, and a ratio of total luminous flux value. The measurement results are shown in Table 2.

### (Chromaticity Variation among Light Emitting Devices)

Five LED devices for each of the samples 1 to 13 were prepared. The chromaticity of light emitted from each LED device was measured using spectroradiometer (CS-1000A, available from Konica Minolta Sensing, Inc.). For the chromaticity, x value and y value were measured in the CIE-XYZ color system. The z-coordinate obtained from the relationship of x+y+z=1 is omitted. Standard deviations of the chromaticity (x value and y value) for 5 samples were determined for each of Examples and Comparative Examples. The mean value of the standard deviations was used for the evaluation. The criteria are as follows.
B: The mean value of the standard deviations is 0.02 or less (applicable to applications requiring uniformly in luminescent color)
C: The mean value of the standard deviations is more than 0.02, and 0.025 or less (practically allowable)

### (Chromaticity Unevenness in one Light Emitting Device)

The chromaticity unevenness in one light emitting device of an LED device was measured using 2D color analyzer (CA-2000, available from Konica Minolta Optics, INC.). Specifically, one light emitting device whose x value of the mean chromaticity of light emitting is 0.33 is selected, the emission surface of the light emitting device is divided into 196x 196, and the standard deviation of the chromaticity for each of the divided surfaces was determined. The criteria are as follows.
B: The standard deviation is 0.02 or less
C: The standard deviation is more than 0.02, and 0.03 or less (practically allowable)
D: The standard deviation is more than 0.03 (practically not preferable)

### (Ratio of Total Luminous Flux Value)

Phosphor dispersion liquids according to the samples 2 to 13 but devoid of light scattering microparticle were prepared, and LED devices (samples) were manufactured according to the method similar to the aforementioned method. The total luminous flux value for each manufactured LED device was measured using spectroradiometer CS-200 (available from Konica Minolta Sensing, Inc.).

Also, LED devices (the same as those manufactured when the chromaticity was measured) were manufactured using the phosphor dispersion liquids prepared in the samples 2 to 13 to measure the total luminous flux values thereof. The ratio of the total luminous flux value in each of samples 2 to 13 to the total luminous flux value of each of corresponding comparative samples 2 to 13 was determined. The ratio was evaluated as follows. When the ratio is 96% or more, it is a practically allowable level.
A: The ratio is 98% or more
B: The ratio is 96% or more, and less than 98%
D: The ratio is less than 96%

**[Table 2]**

| Sample No. | Content in Wavelength Conversion Layer (Phosphor Layer) (%) | | | | | Evaluation | | |
|---|---|---|---|---|---|---|---|---|
| | clay mineral | Silicon Oxide Particles | Light Scattering Microparticles | Phosphor | polysiloxane | Variation | Unevenness | Ratio of Total Luminous Flux Value |
| 1 (Comparative Example) | 2.8 | 4.2 | 0.00 | 83 | 10 | B | D | - |
| 2 (Example) | 2.8 | 4.1 | 0.55 | 83 | 10 | B | B | A(99%) |
| 3 (Example) | 2.7 | 4.1 | 1.99 | 81 | 10 | B | B | B(96%) |
| 4 (Example) | 2.7 | 4.1 | 1.45 | 82 | 10 | B | B | B(97%) |
| 5 (Example) | 2.7 | 4.1 | 0.91 | 82 | 10 | B | B | A(98%) |
| 6 (Example) | 2.8 | 4.1 | 0.09 | 83 | 10 | B | B | A(99%) |
| 7 (Comparative Example) | 2.7 | 4.1 | 2.16 | 81 | 10 | B | B | C(95%) |
| 8 (Comparative Example) | 2.7 | 4.0 | 3.12 | 80 | 10 | B | B | C(92%) |
| 9 (Example) | 2.3 | 3.7 | 0.37 | 84 | 10 | B | B | A(99%) |
| 10 (Example) | 2.7 | 3.7 | 1.19 | 82 | 10 | B | B | A(98%) |
| 11 (Example) | 2.7 | 4.1 | 1.36 | 82 | 10 | B | C | A(99%) |
| 12 (Example) | 1.9 | 1.9 | 1.51 | 85 | 10 | C | B | B(97%) |
| 13 (Example) | 4.3 | 6.9 | 1.38 | 77 | 10 | B | C | B(96%) |

While chromaticity unevenness is generated in sample 1 which does not contain light scattering microparticles in the phosphor layer, generation of chromaticity unevenness can be suppressed in samples 2 to 13 which contain light scattering microparticles in the phosphor layers. However, in sample 11 in which the light scattering microparticles are calcium carbonate having low refractive index, or in sample 13 with high viscosity (1050 mPa·s), chromaticity unevenness is generated to some degree. Further, in samples 7 and 8 in which the amount of light scattering microparticles is large, the ratio of the total luminous flux value, the indicator of the light coupling-out efficiency, is lowered.

Moreover, in sample 12 in which the viscosity of the phosphor dispersion liquid is low (70 mPa·s), chromaticity variation is generated.

### Industrial Applicability

In the LED device in which an encapsulating film (phosphor film) is formed of the phosphor dispersion liquid of the present invention, chromaticity variation among devices is suppressed, and an LED device with low chromaticity unevenness (uniformity in the emission surface of a light emitting device) can be provided.

### Reference Signs List

- 1: Package
- 2: Metal part
- 3: LED chip
- 4: Interconnection
- 6: Wavelength Conversion Layer
- 7: Transparent Resin Layer
- 100: LED device
- 200: Applicator
- 210: Coating Liquid Tank
- 220: Phosphor Dispersion Liquid
- 230: Connector Tube
- 240: Head
- 250: Nozzle
- 270: Discharged Liquid

## Claims

1. A phosphor dispersion liquid containing phosphor particles, light scattering microparticles, laminar clay mineral particles, silicon oxide particles and a solvent, wherein
a light scattering microparticles content is 0.1 to 2.5mass% based on the phosphor particles.

2. The phosphor dispersion liquid according to claim 1, wherein the light scattering microparticles are made of a white pigment.

3. The phosphor dispersion liquid according to claim 1 or 2, wherein a refractive index of the light scattering microparticles is 1.6 or more.

4. The phosphor dispersion liquid according to any one of claims 1 to 3 having a viscosity of 80 to 1,000 mPa·s.

5. The phosphor dispersion liquid according to any one of claims 1 to 4, wherein the solvent is an aliphatic alcohol.

6. An LED device comprising an LED element and a wavelength conversion layer configured to convert light from the LED element to light of another specific wavelength, wherein
the wavelength conversion layer contains a ceramic, phosphor particles bound with the ceramic, light scattering microparticles, laminar clay mineral particles, and silicon oxide particles, wherein
a light scattering microparticles content based on a whole of the wavelength conversion layer is 0.05 to 2mass% in the wavelength conversion layer.

7. The LED device according to claim 6 further comprising a transparent resin layer disposed on an upper surface of the wavelength conversion layer, the upper surface being on an opposite side to the LED element.

8. A method of manufacturing the LED device according to claim 6 or 7 comprising:
preparing an LED element;
applying the phosphor dispersion liquid according to any one of claims 1 to 5 on the LED element to form a phosphor layer;
applying a translucent ceramic material composition including a translucent ceramic material and solvent on an upper surface of a conversion layer of the phosphor layer, the upper surface being on an opposite side to the LED element; and
curing the translucent ceramic material to form a wavelength conversion layer in which the phosphor layer is bound with a translucent ceramic.
